# EUROPEAN PATENT APPLICATION

(11) **EP 4 819 798 A1**
(43) Date of publication of application: **07.10.2026**
(21) Application number: 25219930.2
(22) Date of filing: 02.12.2025
(51) Int. Cl.: H10F 39/00

(54) **IMAGE SENSING DEVICE**

(30) Priority: 01.04.2025 KR 20250042052
(71) Applicant: SK hynix Inc., Bubal-eub Icheon-si Gyeonggi-do 17336 (KR)
(72) Inventor: KIM, Han Jun, 17336 Icheon-si, Gyeonggi-do (KR)
(74) Representative: Isarpatent

(57) **Abstract**

An image sensing device including a pixel isolation structure is disclosed. The image sensing device includes different first and second pixels configured to detect light of the same wavelength range. In the image sensing device, a plurality of first protrusions extending into a first active region within the first pixel and a plurality of second protrusions extending into a second active region within the second pixel have different lengths.

## Description

### TECHNICAL FIELD

The technology and implementations disclosed in this patent document generally relate to an image sensing device, and more particularly to an image sensing device including a pixel isolation structure.

### BACKGROUND

An image sensing device is a device for capturing optical images by converting light into electrical signals using a photosensitive semiconductor material which reacts to light. With the development of automotive, medical, computer and communication industries, the demand for high-performance image sensing devices is increasing in various fields such as smartphones, digital cameras, game machines, IoT (Internet of Things), robots, security cameras and medical micro cameras.

The image sensing device may be roughly divided into CCD (Charge Coupled Device) image sensing devices and CMOS (Complementary Metal Oxide Semiconductor) image sensing devices. The CCD image sensing devices offer a better image quality, but they tend to consume more power and are larger as compared to the CMOS image sensing devices. The CMOS image sensing devices are smaller in size and consume less power than the CCD image sensing devices. Furthermore, CMOS sensors are fabricated using the CMOS fabrication technology, and thus photosensitive elements and other signal processing circuitry can be integrated into a single chip, enabling the production of miniaturized image sensing devices at a lower cost. For these reasons, CMOS image sensing devices are being developed for many applications including mobile devices.

### SUMMARY

Various embodiments of the present disclosure relate to an image sensing device that can solve the problem of having to design a complex circuit to generate an image with a high dynamic range (HDR).

Various embodiments of the present disclosure relate to an image sensing device including a pixel structure that can implement high-sensitivity pixels and low-sensitivity pixels for the same type of pixels (i.e., homogeneous pixels) without designing a complex circuit.

In accordance with an embodiment of the present disclosure, an image sensing device may include: a first pixel including a first active region upon which light of a first wavelength range is incident, and a plurality of first protrusions, each of which extends into the first active region by a first length; and a second pixel including a second active region upon which light of the first wavelength range is incident, and a plurality of second protrusions, each of which extends into the second active region by a second length shorter than the first length.

In some implementations, the plurality of first protrusions may extend from one side of a first pixel isolation structure surrounding the first active region to a center of the first active region. The plurality of second protrusions may extend from one side of a second pixel isolation structure surrounding the second active region to a center of the second active region.

In some implementations, the first pixel may include first and second photoelectric conversion elements that detect light of the first wavelength range, wherein each of the first protrusions is disposed between the first and second photoelectric conversion elements. The second pixel may include third and fourth photoelectric conversion elements that detect light of the first wavelength range, wherein each of the second protrusions is disposed between the third and fourth photoelectric conversion elements.

In some implementations, the first pixel may include first to fourth photoelectric conversion elements that detect light of the first wavelength range; and the second pixel may include fifth to eighth photoelectric conversion elements that detect light of the first wavelength range.

In some implementations, the first protrusion disposed between the first and second photoelectric conversion elements may extend in a first direction; the first protrusion disposed between the third and fourth photoelectric conversion elements may extend in a direction opposite to the first direction; the first protrusion disposed between the first and third photoelectric conversion elements may extend in a second direction; and the first protrusion disposed between the second and third photoelectric conversion elements may extend in a direction opposite to the second direction.

In some implementations, the second protrusion disposed between the fifth and sixth photoelectric conversion elements may extend in the first direction; the second protrusion disposed between the seventh and eighth photoelectric conversion elements may extend in a direction opposite to the first direction; the second protrusion disposed between the fifth and seventh photoelectric conversion elements may extend in the second direction; and the second protrusion disposed between the sixth and seventh photoelectric conversion elements may extend in a direction opposite to the second direction.

In some implementations, the first pixel may have a lower sensitivity than the second pixel.

In some implementations, the image sensing device may further include: a third pixel including a third active region upon which light of a second wavelength range is incident, and a third protrusion extending into the third active region by a third length; and a fourth pixel including a fourth active region upon which light of the second wavelength range is incident, and a fourth protrusion extending into the fourth active region by the third length.

In some implementations, the image sensing device may further include: a third pixel including a third active region upon which light of a first wavelength range is incident, and a third protrusion extending into the third active region by the second length; and a fourth pixel including a fourth active region upon which light of the first wavelength range is incident, and a fourth protrusion extending into the fourth active region by the second length.

In some implementations, the image sensing device may further include: a fifth pixel including a fifth active region upon which light of a second wavelength range is incident, and a fifth protrusion extending into the fifth active region by the first length; a sixth pixel including a sixth active region upon which light of the second wavelength range is incident, and a sixth protrusion extending into the sixth active region by the second length; a seventh pixel including a seventh active region upon which light of a second wavelength range is incident, and a seventh protrusion extending into the seventh active region by the second length; and an eighth pixel including an eighth active region upon which light of the second wavelength range is incident, and an eighth protrusion extending into the eighth active region by the second length.

In accordance with another embodiment of the present disclosure, an image sensing device may include: a pixel array including a pixel isolation structure disposed along boundaries of a plurality of pixels. The pixel array may include: a first pixel group including first and second pixels that detect light of a first wavelength range. The first pixel may include a plurality of first protrusions, each of which extends from the pixel isolation structure to a center of the first pixel by a first length. The second pixel may include a plurality of second protrusions, each of which extends from the pixel isolation structure to a center of the second pixel by a second length shorter than the first length.

In some implementations, the plurality of first protrusions may include: a first protrusion extending from the pixel isolation structure in a first direction; and another first protrusion extending from the pixel isolation structure in a direction opposite to the first direction.

In some implementations, the plurality of first protrusions may further include: a first protrusion extending from the pixel isolation structure in a second direction; and another first protrusion extending from the pixel isolation structure in a direction opposite to the second direction.

In some implementations, the plurality of second protrusions may include: a second protrusion extending from the pixel isolation structure in a first direction; and another second protrusion extending from the pixel isolation structure in a direction opposite to the first direction.

In some implementations, the first pixel group may further include: third and fourth pixels configured to detect light of the first wavelength range, wherein the first to fourth pixels are arranged in a (2 × 2) matrix structure.

In some implementations, the third pixel may include a plurality of third protrusions extending from the pixel isolation structure to a center of the third pixel by the second length; and the fourth pixel may include a plurality of fourth protrusions extending from the pixel isolation structure to a center of the fourth pixel by the second length.

In some implementations, the third pixel may include a plurality of third protrusions, each of which extends from the pixel isolation structure to a center of the third pixel by the first length; and the fourth pixel may include a plurality of fourth protrusions, each of which extends from the pixel isolation structure to a center of the fourth pixel by the second length.

In some implementations, the pixel array may further include: fifth and sixth pixels configured to detect light of a second wavelength range. The fifth pixel may include a plurality of fifth protrusions, each of which extends from the pixel isolation structure to a center of the fifth pixel by the first length. The sixth pixel may include a plurality of sixth protrusions, each of which extends from the pixel isolation structure to a center of the sixth pixel by the second length.

In some implementations, the plurality of fifth protrusions may include: a fifth protrusion configured to extend from the pixel isolation structure in a first direction; and a fifth protrusion configured to extend from the pixel isolation structure in a direction opposite to the first direction.

In some implementations, the plurality of fifth protrusions may include: a fifth protrusion configured to extend from the pixel isolation structure in a second direction; and a fifth protrusion configured to extend from the pixel isolation structure in a direction opposite to the second direction.

In some implementations, the plurality of sixth protrusions may include: a sixth protrusion configured to extend from the pixel isolation structure in the first direction; and a sixth protrusion configured to extend from the pixel isolation structure in a direction opposite to the first direction.

In some implementations, each of the first protrusion and the second protrusion may be perpendicular to the pixel isolation structure.

It is to be understood that both the foregoing general description and the following detailed description of the present disclosure are illustrative and explanatory and are intended to provide further explanation of the present disclosure as claimed.

### BRIEF DESCRIPTION OF THE DRAWINGS

Various examples and implementations of the above and other features and beneficial aspects of the present disclosure are described with reference to the following detailed description and the accompanying drawings.
FIG. 1 is a block diagram illustrating an example of an image sensing device based on some embodiments of the present disclosure.
FIG. 2 is a plan view illustrating an example of a pixel array based on some embodiments of the present disclosure.
FIG. 3 is a plan view illustrating a first embodiment of a pixel region shown in FIG. 2 based on some embodiments of the present disclosure.
FIG. 4 is a cross-sectional view illustrating an example of the pixel region taken along the line A-A' shown in FIG. 3 based on some embodiments of the present disclosure.
FIG. 5 is a graph illustrating changes in sensitivity and changes in crosstalk according to the lengths of protrusions shown in FIG. 3 based on some embodiments of the present disclosure.
FIG. 6 is a plan view illustrating a second embodiment of the pixel region shown in FIG. 2 based on some embodiments of the present disclosure.

### DETAILED DESCRIPTION

This patent document provides implementations and examples of an image sensing device including a pixel isolation structure that may be used in configurations to substantially address one or more technical or engineering issues and to mitigate limitations or disadvantages encountered in some other image sensing devices. Some implementations of the present disclosure relate to an image sensing device that can solve the problem of having to design a complex circuit to generate an image with a high dynamic range (HDR). Some implementations of the present disclosure relate to an image sensing device including a pixel structure that can implement high-sensitivity pixels and low-sensitivity pixels for the same type of pixels (i.e., homogeneous pixels) without designing a complex circuit. Some implementations of the present disclosure may provide an image sensing device that has a high dynamic range (HDR) by varying the sensitivities of pixels that detect light of the same wavelength range without designing a separate, complex circuit.

Hereinafter, various implementations and embodiments of the disclosed technology are described with reference to the accompanying drawings. It should be understood that the present disclosure is not limited to specific embodiments, but includes various modifications, equivalents and/or alternatives of the embodiments. The embodiments of the present disclosure may provide a variety of effects capable of being directly or indirectly recognized through the present disclosure.

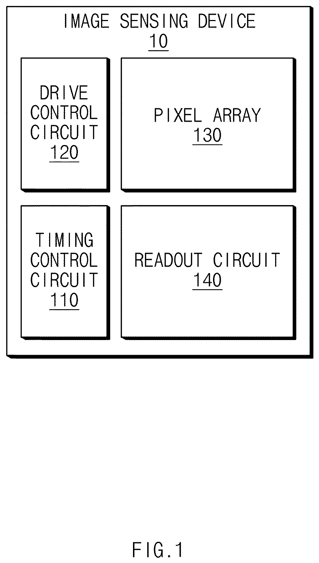

FIG. 1 is a schematic diagram illustrating an example of an image sensing device 10 based on some embodiments of the present disclosure.

Referring to FIG. 1, the image sensing device 10 according to an exemplary embodiment of the present disclosure may include a timing control circuit 110, a drive control circuit 120, a pixel array 130, and a readout circuit 140. The constituent components of the image sensing device 10 illustrated in FIG. 1 are discussed by way of example only, and this patent document encompasses numerous other changes, substitutions, variations, alterations, and modifications. In this patent document, the word "pixel" can be used to indicate an image sensing pixel that is structured to detect incident light to generate electrical signals carrying images in the incident light. For example, the image sensing device 10 may be a Complementary Metal Oxide Semiconductor (CMOS) image sensor configured to convert incident light into an electrical signal.

The timing control circuit 110 may generate a timing signal to control the operations of the drive control circuit 120 and the readout circuit 140. In some implementations, the timing control circuit 110 may generate a timing signal in response to a request from an external processor (e.g., an image signal processor ISP). In some implementations, the timing control circuit 110 may include a logic control circuit, a phase-locked loop (PLL) circuit, a communication interface circuit, and the like.

The drive control circuit 120 may drive pixels (PXs) of the pixel array 130 in response to a timing signal output from the timing control circuit 110. The drive control circuit 120 may select and control pixels (PXs) included in at least one row line from among a plurality of row lines of the pixel array 130. The drive control circuit 120 may generate a row selection signal to select at least one row from among the plurality of rows. The drive control circuit 120 may sequentially enable a pixel reset signal and a transfer signal for pixels (PXs) corresponding to at least one selected row. Accordingly, an analog reference signal and an image signal generated from each of the pixels (PXs) of the selected row may be sequentially transmitted to the readout circuit 140. The reference signal may be an electrical signal provided to the readout circuit 140 when a floating diffusion region (FD) of each pixel is reset to a power-supply voltage (VDD). The image signal may be an electrical signal provided to the readout circuit 140 when photocharges generated by each pixel are accumulated in the floating diffusion region (FD). The reference signal indicating unique pixel noise of each pixel, and the image signal indicating the intensity of incident light may be collectively referred to as a pixel signal as necessary.

The pixel array 130 may include a plurality of pixels (PXs) arranged in rows and columns. In one example, the plurality of pixels (PXs) can be arranged in a two-dimensional (2D) pixel array including rows and columns. In another example, the plurality of pixels (PXs) can be arranged in a three-dimensional (3D) pixel array. The plurality of pixels (PXs) may convert an optical signal into an electrical signal on a pixel basis or a pixel group basis including multiple pixels, and may output a pixel signal. Here, the pixels in a pixel group of the pixel array 130 may share at least certain internal circuitry. The pixel array 130 may receive driving signals including a row selection signal, a pixel reset signal, a transfer signal, etc. from the drive control circuit 120. Upon receiving the driving signals, corresponding imaging pixels in the pixel array 130 may be activated to perform the operations corresponding to the row selection signal, the pixel reset signal, and the transfer signal.

The readout circuit 140 may detect a pixel signal output from the pixel array 130 under the control of the timing control circuit 110, and may output the detected pixel signal as image data. The image data may be digital data generated by performing an analog-to-digital conversion process on an analog pixel signal. To this end, the readout circuit 140 may include a correlated double sampler (CDS) for performing correlated double sampling on pixel signals output from the pixel array 130. In addition, the readout circuit 140 may include an analog-to-digital converter (ADC) for converting signals output from the correlated double sampler (CDS) into digital signals to generate pixel data. In addition, the readout circuit 140 may include a buffer circuit for temporarily storing pixel data output from the analog-to-digital converter (ADC) and outputting the stored pixel data to the outside under the control of the timing control circuit 110. The correlated double sampler (CDS) may remove the undesired offset value of pixels by comparing pixel output voltages obtained before and after photocharges generated by the pixels in responding to detected incident light are accumulated in the floating diffusion region (FD) so that only pixel output voltages based on the incident light can be measured. The readout circuit 140 may sequentially sample and hold voltage levels of the reference signal and the image signal, which are provided to each of a plurality of column lines from the pixel array 130. That is, the readout circuit 140 may sample and hold the voltage levels of the reference signal and the image signal which correspond to each of the columns of the pixel array 130. The readout circuit 140 may convert a correlated double sampler (CDS) signal, which is an analog signal for each column, into a digital signal, and may output the digital signal for each column. The readout circuit 140 may temporarily hold image data for each column, and may output the image data to, for example, an image processing device (not shown).

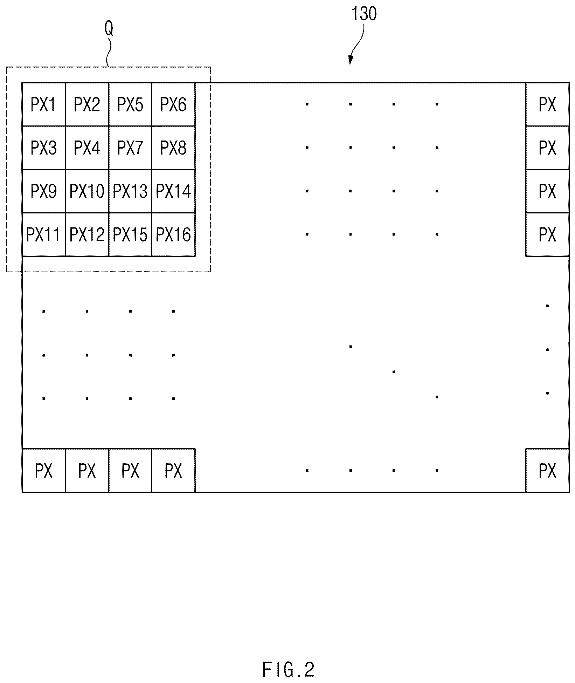

FIG. 2 is a plan view illustrating an example of the pixel array 130 of the image sensing device 10 shown in FIG. 1 based on some embodiments of the present disclosure.

Referring to FIGS. 1 and 2, the pixel array 130 may include, for example, a structure in which a plurality of pixels (PXs) is arranged in a two-dimensional (2D) matrix. The pixel array 130 may include M pixels (PXs) arranged in a horizontal direction (row direction) (where 'M' is an integer greater than or equal to 2). The pixel array 130 may include N pixels (PXs) arranged in a vertical direction (where 'N' is an integer greater than or equal to 2). In the example, the pixel array 130 may include a plurality of pixels including first to fourth pixels (PX1~PX4). The first to fourth pixels (PX1~PX4) may be arranged in a (2 × 2) matrix structure.

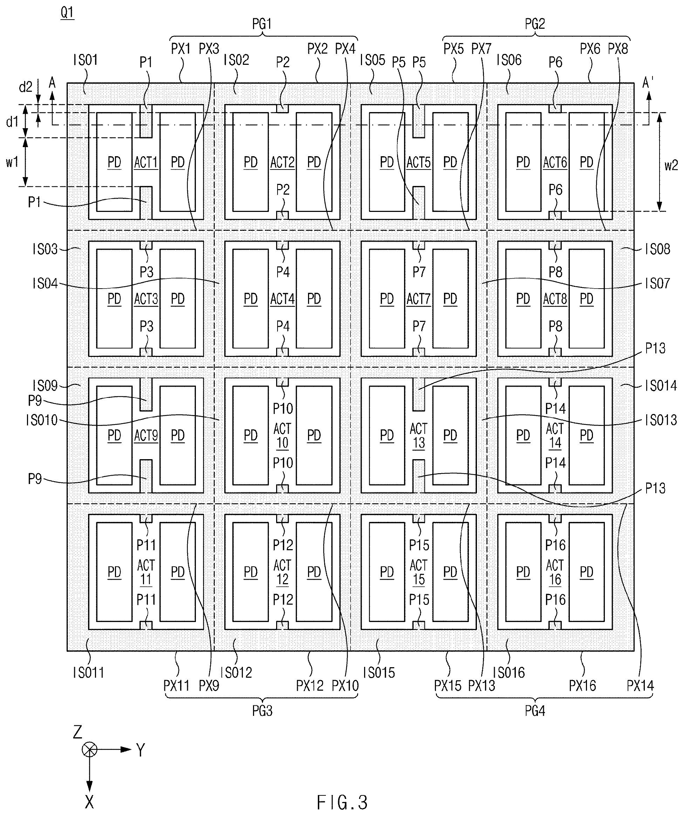

The pixel array 130 may include a pixel isolation structure (not shown) arranged along boundaries of the plurality of pixels. The pixel isolation structure will be described later with reference to FIG. 3 and below.

The pixel array 130 may include a pixel region (Q) including first to sixteenth pixels (PX1~PX16). In the pixel region (Q), 16 pixels (PX1~PX16) are arranged in a (4 × 4) matrix structure including four rows and four columns. More detailed embodiments of the pixel region (Q) will be described in the below with reference to FIG. 3.

FIG. 3 is a plan view illustrating a first embodiment of four adjacent pixels PX1, PX2, PX5 and PX6 in a row within the pixel region (Q) shown in FIG. 2 based on some embodiments of the present disclosure.

Referring to FIGS.2 and 3, the pixel region (Q1) according to the first embodiment may include first to fourth pixel groups (PG1~PG4) with each pixel group having 4 adjacent pixels: e.g., the first pixel group PG1 includes a 2-by-2 matrix of adjacent pixels PX1 through PX4, and the second pixel group PG2 includes a 2-by-2 matrix of adjacent pixels PX5 through PX8, and so on. The first to fourth pixel groups (PG1~PG4) may be arranged in a (2 × 2) matrix structure. The first to fourth pixel groups (PG1~PG4) may be designed and structured to detect light in different ranges of wavelengths.

The first pixel group (PG1) may include first to fourth pixels (PX1~PX4) as shown in FIGS. 2 and 3. For example, the first to fourth pixels (PX1~PX4) may be arranged in a (2 × 2) matrix structure including two rows and two columns. Referring to illustrated examples of PX1 and PX2 in FIG. 3, each of the first to fourth pixels (PX1~PX4) may include a microlens (not shown) that converges incident light onto a photoelectric conversion element. Each of the first to fourth pixels (PX1~PX4) may include a color filter (not shown) that selectively transmits light in a first wavelength range (e.g., green light to orange light at wavelengths from 500 nm to 600 nm). Each of the first to fourth pixels (PX1~PX4) may detect light in the first wavelength range without detecting light outside the first wavelength range due to the presence of color filters(not shown). For example, each of the first to fourth pixels (PX1~PX4) may include a photoelectric conversion element that detects light in the first wavelength range and generates photocharge indicative of the detected green light.

The second pixel group (PG2) may include fifth to eighth pixels (PX5~PX8) as shown in FIGS. 2 and 3. For example, the fifth to eighth pixels (PX5~PX8) may be arranged in a (2 × 2) matrix structure including two rows and two columns. Referring to the examples of PX5 and PX6 in FIG. 3, each of the fifth to eighth pixels (PX5~PX8) may include a microlens (not shown) that converges incident light onto a photoelectric conversion element. Each of the fifth to eighth pixels (PX5~PX8) may include a color filter (not shown) that selectively transmits light in a second wavelength range (e.g., blue to greenish light in wavelengths from 400 nm to 500 nm). Each of the fifth to eighth pixels (PX5~PX8) may detect light in the second wavelength range. For example, each of the fifth to eighth pixels (PX5~PX8) may include a photoelectric conversion element that detects light in the second wavelength range and generates photocharge indicative of the detected blue light.

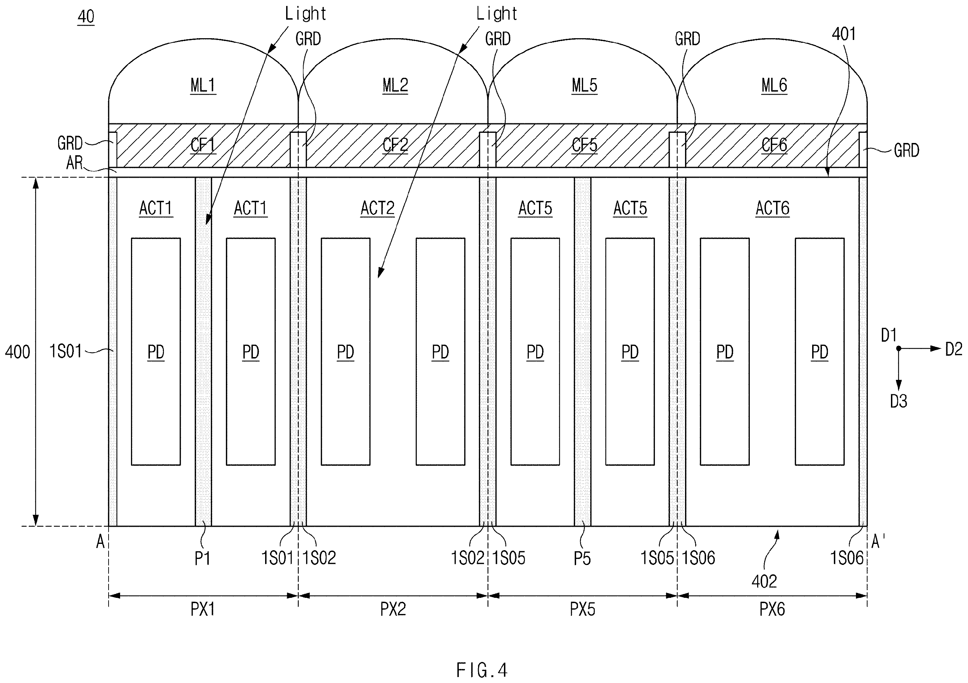

The third pixel group (PG3) may include ninth to twelfth pixels (PX9~PX12) as shown in FIGS. 2 and 4. For example, the ninth to twelfth pixels (PX9~PX12) may be arranged in a (2 × 2) matrix structure including two rows and two columns. Each of the ninth to twelfth pixels (PX9~PX12) may include a microlens (not shown) that converges incident light onto a photoelectric conversion element. Each of the ninth to twelfth pixels (PX9~PX12) may include a color filter (not shown) that selectively transmits light in a third wavelength range (e.g., red light in wavelengths from 600 nm to 700 nm). Each of the ninth to twelfth pixels (PX9~PX12) may detect light in the third wavelength range. For example, each of the ninth to twelfth pixels (PX9~PX12) may include a photoelectric conversion element that detects light in the third wavelength range and generates photocharge indicative of the detected red light.

The fourth pixel group (PG4) may include thirteenth to sixteenth pixels (PX13~PX16). For example, the thirteenth to sixteenth pixels (PX13~PX16) may be arranged in a (2 × 2) matrix structure including two rows and two columns. Each of the thirteenth to sixteenth pixels (PX13~PX16) may include a microlens (not shown) that converges incident light onto a photoelectric conversion element. Each of the thirteenth to sixteenth pixels (PX13~PX16) may include a color filter (not shown) that selectively transmits light in the first wavelength range or a fourth wavelength range (e.g., deep to dark red light in wavelengths at 700 nm or longer wavelengths). The following embodiments will hereinafter be described that each of the thirteenth to sixteenth pixels (PX13~PX16) may detect light in the first wavelength range. For example, each of the thirteenth to sixteenth pixels (PX13~PX16) may include a photoelectric conversion element that detects light in the first wavelength range and generates photocharge indicative of the detected deep and dark red light.

Referring to the example for the pixel structure FIG. 3, the first pixel (PX1) may include a first active region (ACT1) and a first pixel isolation structure (ISO1) disposed on sides of the first active region (ACT1). In the example, the first pixel isolation structure (ISO1) may surround the first active region (ACT1).

In the example in FIG. 3, the first active region (ACT1) may include two photoelectric conversion elements (PDs). The two photoelectric conversion elements (PDs) may be spaced apart from each other. A first protrusion (P1) may be disposed between the two photoelectric conversion elements (PDs) in the first active region (ACT1). Each of the two photoelectric conversion elements (PDs) may generate photocharges in response to incident light received in the first active region (ACT1). The first active region (ACT1) may be or include a semiconductor region including impurities of a first conductivity type (e.g., P-type). Each of the two photoelectric conversion elements (PDs) may be or include a semiconductor region including impurities of a second conductivity type (e.g., N-type).

Referring to FIGS. 3, the first pixel isolation structure (ISO1) may be disposed outside of the first active region and surround the first active region (ACT1). The first pixel isolation structure (ISO1) may include a first protrusion (P1) disposed between two photoelectric conversion elements (PDs). Referring to the example as shown in FIG. 3, the two first protrusions (P1) are disposed in the first pixel (PX1). Each of the first protrusion (P1) may extend from the first pixel isolation structure (ISO1) into the first active region (ACT1) by a first length (d1). The first protrusion (P1) may extend from one side (e.g., from the top in the example shown in FIG. 3) of the first pixel isolation structure (ISO1) to the center of the first active region (ACT1). For example, the first protrusion (P1) may extend from one side of the first pixel isolation structure (ISO1) in the first direction (X). Another first protrusion (P1) may extend from the other side (e.g., from the bottom in the example shown in FIG. 3) of the first pixel isolation structure (ISO1) to the center of the first active region (ACT1). For example, another first protrusion (P1) may extend from the other side of the first pixel isolation structure (ISO1) in a direction opposite to the first direction (X). In the example as shown in FIG. 3, the first protrusions (P1) extend from two opposite sides of the first pixel isolation structure (ISO1). These two sides are the ones that face each other. The first protrusions (P1) extending from two sides of the first pixel isolation structure (ISO1) to the center of the first active region (ACT1) may be spaced apart from each other.

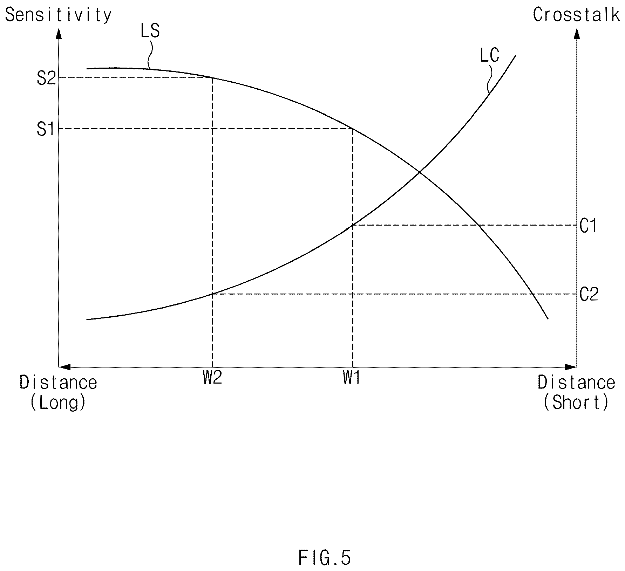

The first pixel isolation structure (ISO1) may include an insulation material (e.g., silicon oxide, silicon nitride, etc.). The first pixel isolation structure (ISO1) may reduce crosstalk between the first pixel (PX1) and another pixel adjacent to the first pixel (PX1). The first protrusions (P1) may reduce crosstalk between two photoelectric conversion elements (PDs) arranged in the first pixel (PX1). The degree of crosstalk reduction may vary depending on the length of the first protrusions (P1), which will be described later with reference to FIG. 5.

In the following description of the second to sixteenth pixels (PX2~PX16), descriptions overlapping with those described in the first pixel (PX1) will herein be omitted as much as possible. The following embodiments will hereinafter be described with a focus on characteristics that are different from those of the first pixel (PX1).

Referring to examples in FIGS. 3, the second pixel (PX2) may include a second active region (ACT2) and a second pixel isolation structure (ISO2) surrounding the second active region (ACT2). The second active region (ACT2) may include two photoelectric conversion elements (PDs). The second pixel isolation structure (ISO2) may include a second protrusion (P2) disposed between the two photoelectric conversion elements (PDs). Referring to the example as shown in FIG. 3, the two second protrusions (P2) are disposed in the second pixel (PX2). Each of the second protrusion (P2) may extend from the second pixel isolation structure (ISO2) into the second active region (ACT2) by a second length (d2). The second length (d2) may be shorter than the first length (d1). Similarly to the first protrusion (P1) in the first pixel PX1, the second protrusions (P2) may extend from both sides of the pixel isolation structure toward the center of the second active region (ACT2) or the center of the second pixel (PX2). The second protrusion (P2) may extend from one side of the pixel isolation structure in the first direction (X) and another second protrusion (P2) may extend from the other side of the pixel isolation structure along a direction opposite to the first direction (X)

The second pixel (PX2) may have a protrusion length different from that of the first pixel (PX1), but may be substantially the same as the first pixel (PX1) except for such difference in protrusion length. The second pixel (PX2) may be disposed adjacent to the first pixel (PX1) in the second direction (Y).

In the following description of the third to sixteenth pixels (PX3~PX16), descriptions overlapping with those described in the first pixel (PX1) or the second pixel (PX2) will herein be omitted as much as possible.

Referring to FIGS. 2 and 3, the third pixel (PX3) may be disposed adjacent to the first pixel (PX1) along the first direction (X). The remaining internal structures of the third pixel (PX3) except for the arrangement position of the third pixel (PX3) may be substantially the same as those of the second pixel (PX2). For example, the third pixel (PX3) may include a third active region (ACT3) and a third pixel isolation structure (ISO3). The third active region (ACT3) may include two photoelectric conversion elements (PDs). The third pixel (PX3) may include third protrusions (P3) extending into the interior of the third active region (ACT3) along the first direction (X) and the opposite direction of the first direction (X), between the two photoelectric conversion elements (PDs). Each of the third protrusions (P3) may extend by the second length (d2).

Referring to FIGS. 2 and 3, the fourth pixel (PX4) may be disposed in the first direction (X) from the second pixel (PX2). The fourth pixel (PX4) may be disposed in the second direction (Y) from the third pixel (PX3). The remaining internal structures of the fourth pixel (PX5) except for the arrangement position of the fourth pixel (PX4) may be substantially the same as those of the second pixel (PX2). For example, the fourth pixel (PX4) may include a fourth active region (ACT4) and a fourth pixel isolation structure (ISO4). The fourth active region (ACT4) may include two photoelectric conversion elements (PDs). The fourth pixel (PX4) may include fourth protrusions (P4) extending into the interior of the fourth active region (ACT4) along the first direction (X) and the opposite direction of the first direction (X), between the two photoelectric conversion elements (PDs). The fourth protrusion (P4) may also extend by the second length (d2).

For example, as shown in FIGS. 2 and 3, the fifth pixel (PX5) may be disposed in the second direction (Y) from the second pixel (PX2). The remaining internal structures of the fifth pixel (PX5) except for the arrangement position of the fifth pixel (PX5) and a wavelength range of light that selectively penetrates the color filter may be substantially the same as those of the first pixel (PX1). For example, the fifth pixel (PX5) may include a fifth active region (ACT5) and a fifth pixel isolation structure (ISO5). The fifth active region (ACT5) may include two photoelectric conversion elements (PDs). The fifth pixel (PX5) may include fifth protrusions (P5) extending into the interior of the fifth active region (ACT5) along the first direction (X) and the opposite direction of the first direction (X), between the two photoelectric conversion elements (PDs). Each of the fifth protrusions (P5) may also extend by the first length (d1).

As shown in FIGS. 2 and 3, the sixth pixel (PX6) may be disposed in the second direction (Y) from the fifth pixel (PX5). The remaining internal structures of the sixth pixel (PX6) except for the arrangement position of the sixth pixel (PX6) and a wavelength range of light that selectively penetrates its color filter in the sixth pixel (PX6) may be substantially the same as those of the second pixel (PX2). For example, the sixth pixel (PX6) may include a sixth active region (ACT6) and a sixth pixel isolation structure (ISO6). The sixth active region (ACT6) may include two photoelectric conversion elements (PDs). The sixth pixel (PX6) may include sixth protrusions (P6) extending into the interior of the sixth active region (ACT6) along the first direction (X) and the opposite direction of the first direction (X), between the two photoelectric conversion elements (PDs). Each of the sixth protrusions (P6) may also extend by the second length (d2) in the same manner as the second protrusion (P2).

As shown in FIGS. 2 and 3, the seventh pixel (PX7) may be disposed in the first direction (X) from the fifth pixel (PX5). The remaining internal structures of the seventh pixel (PX7) except for the arrangement position of the seventh pixel (PX7) and a wavelength range of light that selectively penetrates the color filter in the seventh pixel (PX7) may be substantially the same as those of the second pixel (PX2). For example, the seventh pixel (PX7) may include a seventh active region (ACT7) and a seventh pixel isolation structure (ISO7). The seventh active region (ACT7) may include two photoelectric conversion elements (PDs). The seventh pixel (PX7) may include seventh protrusions (P7) extending into the interior of the seventh active region (ACT7) along the first direction (X) and the opposite direction of the first direction (X), between the two photoelectric conversion elements (PDs). Each of the seventh protrusions (P7) may also extend by the second length (d2) in the same manner as the second protrusion (P2).

As shown in FIGS. 2 and 3, the eighth pixel (PX8) may be disposed in the first direction (X) from the sixth pixel (PX6). The eighth pixel (PX8) may be disposed in the second direction (Y) from the seventh pixel (PX7). The remaining internal structures of the eighth pixel (PX8) except for the arrangement position of the eighth pixel (PX8) and a wavelength range of light that selectively penetrates the color filter in the eighth pixel (PX8) may be substantially the same as those of the second pixel (PX2). For example, the eighth pixel (PX8) may include an eighth active region (ACT8) and an eighth pixel isolation structure (ISO8). The eighth active region (ACT8) may include two photoelectric conversion elements (PDs). The eighth pixel (PX8) may include eighth protrusions (P8) extending into the interior of the eighth active region (ACT8) along the first direction (X) and the opposite direction of the first direction (X), between the two photoelectric conversion elements (PDs). Each of the eighth protrusions (P8) may also extend by the second length (d2) in the same manner as the second protrusion (P2).

As shown in FIGS. 2 and 3, the ninth pixel (PX9) may be disposed in the first direction (X) from the third pixel (PX3). Since the ninth pixel (PX9) detects light of a third wavelength range in a different way from the first pixel (PX1) configured to detect light of the first wavelength range, the remaining internal structures of the ninth pixel (PX9) except for the arrangement position of the ninth pixel (PX9) and a wavelength range of light that selectively penetrates the color filter in the ninth pixel (PX9) may be substantially the same as those of the first pixel (PX1). For example, the ninth pixel (PX9) may include a ninth active region (ACT9) and a ninth pixel isolation structure (ISO9). The ninth active region (ACT9) may include two photoelectric conversion elements (PDs). The ninth pixel (PX9) may include ninth protrusions (P9) extending into the interior of the ninth active region (ACT9) along the first direction (X) and the opposite direction of the first direction (X), between the two photoelectric conversion elements (PDs). Each of the ninth protrusions (P9) may also extend by the first length (d1) in the same manner as the first protrusion (P1).

As shown in FIGS. 2 and 3, the tenth pixel (PX10) may be disposed in the second direction (Y) from the ninth pixel (PX9). The remaining internal structures of the tenth pixel (PX10) except for the arrangement position of the tenth pixel (PX10) and a wavelength range of light that selectively penetrates the color filter in the tenth pixel (PX10) may be substantially the same as those of the second pixel (PX2). For example, the tenth pixel (PX10) may include a tenth active region (ACT10) and a tenth pixel isolation structure (ISO10). The tenth active region (ACT10) may include two photoelectric conversion elements (PDs). The tenth pixel (PX10) may include tenth protrusions (P10) extending into the interior of the tenth active region (ACT10) along the first direction (X) and the opposite direction of the first direction (X), between the two photoelectric conversion elements (PDs). Each of the tenth protrusions (P10) may also extend by the second length (d2) in the same manner as the second protrusion (P2).

As shown in FIGS. 2 and 3, the eleventh pixel (PX11) may be disposed in the first direction (X) from the ninth pixel (PX9). The remaining internal structures of the eleventh pixel (PX11) except for the arrangement position of the eleventh pixel (PX11) and a wavelength range of light that selectively penetrates the color filter in the eleventh pixel (PX11) may be substantially the same as those of the second pixel (PX2). For example, the eleventh pixel (PX11) may include an eleventh active region (ACT11) and an eleventh pixel isolation structure (ISO11). The eleventh active region (ACT11) may include two photoelectric conversion elements (PDs). The eleventh pixel (PX11) may include eleventh protrusions (P11) extending into the interior of the eleventh active region (ACT11) along the first direction (X) and the opposite direction of the first direction (X) between the two photoelectric conversion elements (PDs). Each of the eleventh protrusions (P11) may also extend by the second length (d2) in the same manner as the second protrusion (P2).

As shown in FIGS. 2 and 3, the twelfth pixel (PX12) may be disposed in the first direction (X) from the tenth pixel (PX10). The twelfth pixel (PX12) may be disposed in the second direction (Y) from the eleventh pixel (PX11). The remaining internal structures of the twelfth pixel (PX12) except for the arrangement position of the twelfth pixel (PX12) and a wavelength range of light that selectively penetrates the color filter in the twelfth pixel (PX12) may be substantially the same as those of the second pixel (PX2). For example, the twelfth pixel (PX12) may include a twelfth active region (ACT12) and a twelfth pixel isolation structure (ISO12). The twelfth active region (ACT12) may include two photoelectric conversion elements (PDs). The twelfth pixel (PX12) may include twelfth protrusions (P12) extending into the interior of the twelfth active region (ACT12) along the first direction (X) and the opposite direction of the first direction (X) between the two photoelectric conversion elements (PDs). Each of the twelfth protrusions (P12) may also extend by the second length (d2) in the same manner as the second protrusion (P2).

As shown in FIGS. 2 and 3, the thirteenth pixel (PX13) may be disposed in the second direction (Y) from the tenth pixel (PX10). The remaining internal structures of the thirteenth pixel (PX13) except for the arrangement position of the thirteenth pixel (PX13) and a wavelength range of light that selectively penetrates the color filter in the thirteenth pixel (PX13) may be substantially the same as those of the first pixel (PX1). For example, the thirteenth pixel (PX13) may include a thirteenth active region (ACT13) and a thirteenth pixel isolation structure (ISO13). The thirteenth active region (ACT13) may include two photoelectric conversion elements (PDs). The thirteenth pixel (PX13) may include thirteenth protrusions (P13) extending into the interior of the thirteenth active region (ACT13) along the first direction (X) and the opposite direction of the first direction (X) between the two photoelectric conversion elements (PDs). Each of the thirteenth protrusions (P13) may also extend by the first length (d1).

As shown in FIGS. 2 and 3, the fourteenth pixel (PX14) may be disposed in the second direction (Y) from the thirteenth pixel (PX13). The remaining internal structures of the fourteenth pixel (PX14) except for the arrangement position of the fourteenth pixel (PX14) and a wavelength range of light that selectively penetrates the color filter in the fourteenth pixel (PX14) may be substantially the same as those of the second pixel (PX2). For example, the fourteenth pixel (PX14) may include a fourteenth active region (ACT14) and a fourteenth pixel isolation structure (ISO14). The fourteenth active region (ACT14) may include two photoelectric conversion elements (PDs). The fourteenth pixel (PX14) may include fourteenth protrusions (P14) extending into the interior of the fourteenth active region (ACT14) in along the first direction (X) and the opposite direction of the first direction (X) between the two photoelectric conversion elements (PDs). Each of the fourteenth protrusions (P14) may also extend by the second length (d2) in the same manner as the second protrusion (P2).

As shown in FIGS. 2 and 3, the fifteenth pixel (PX15) may be disposed in the first direction (X) from the thirteenth pixel (PX13). The remaining internal structures of the fifteenth pixel (PX15) except for the arrangement position of the fifteenth pixel (PX15) and a wavelength range of light that selectively penetrates the color filter in the fifteenth pixel (PX15) may be substantially the same as those of the second pixel (PX2). For example, the fifteenth pixel (PX15) may include a fifteenth active region (ACT15) and a fifteenth pixel isolation structure (ISO15). The fifteenth active region (ACT15) may include two photoelectric conversion elements (PDs). The fifteenth pixel (PX15) may include fifteenth protrusions (P15) extending into the interior of the fifteenth active region (ACT15) along the first direction (X) and the opposite direction of the first direction (X) between the two photoelectric conversion elements (PDs). Each of the fifteenth protrusions (P15) may also extend by the second length (d2) in the same manner as the second protrusion (P2).

As shown in FIGS. 2 and 3, the sixteenth pixel (PX16) may be disposed in the first direction (X) from the fourteenth pixel (PX14). The sixteenth pixel (PX16) may be disposed in the second direction (Y) from the fifteenth pixel (PX15). The remaining internal structures of the sixteenth pixel (PX16) except for the arrangement position of the sixteenth pixel (PX16) and a wavelength range of light that selectively penetrates the color filter in the sixteenth pixel (PX16) may be substantially the same as those of the second pixel (PX2). For example, the sixteenth pixel (PX16) may include a sixteenth active region (ACT16) and a sixteenth pixel isolation structure (ISO16). The sixteenth active region (ACT16) may include two photoelectric conversion elements (PDs). The sixteenth pixel (PX16) may include sixteenth protrusions (P16) extending into the interior of the sixteenth active region (ACT16) along the first direction (X) and the opposite direction of the first direction (X) between the two photoelectric conversion elements (PDs). Each of the sixteenth protrusions (P16) may also extend by the second length (d2) in the same manner as the second protrusion (P2).

As will be described later with reference to FIG. 5, since pixels (PX1, PX5, PX9, PX13) respectively including protrusions (P1, P5, P9, P13), each extending by the first length (d1), are configured to have active regions (ACT1, ACT5, ACT9, ACT13) having relatively small areas, the sensitivity of each of the pixels (PX1, PX5, PX9, PX13) may be relatively low. Accordingly, the pixels (PX1, PX5, PX9, PX13) will hereinafter be referred to as low-sensitivity pixels. On the other hand, since pixels (PX2~PX4, PX6~PX8, PX10~PX12, PX14~PX16) respectively including protrusions (P2~P4, P6~P8, P10~P12, P14~P16), each extending by the second length (d2), are configured to have active regions (ACT2~ACT4, ACT6~ACT8, ACT10~ACT12) having relatively large areas, the sensitivity of each of the pixels (PX2~PX4, PX6~PX8, PX10~PX12, PX14~PX16) may be relatively high. Accordingly, the pixels (PX2~PX4, PX6~PX8, PX10~PX12, PX14~PX16) will hereinafter be referred to as high-sensitivity pixels.

According to one embodiment, each of the first to fourth pixel groups (PG1~PG4) may include one low-sensitivity pixel and three high-sensitivity pixels. However, other implementations are possible such that the low-sensitivity pixels and the high-sensitivity pixels may have various composition ratios depending on the configuration of the pixel groups. According to another embodiment, each of the first to fourth pixel groups (PG1~PG4) may include two low-sensitivity pixels and two high-sensitivity pixels, unlike the illustration in FIG. 3.

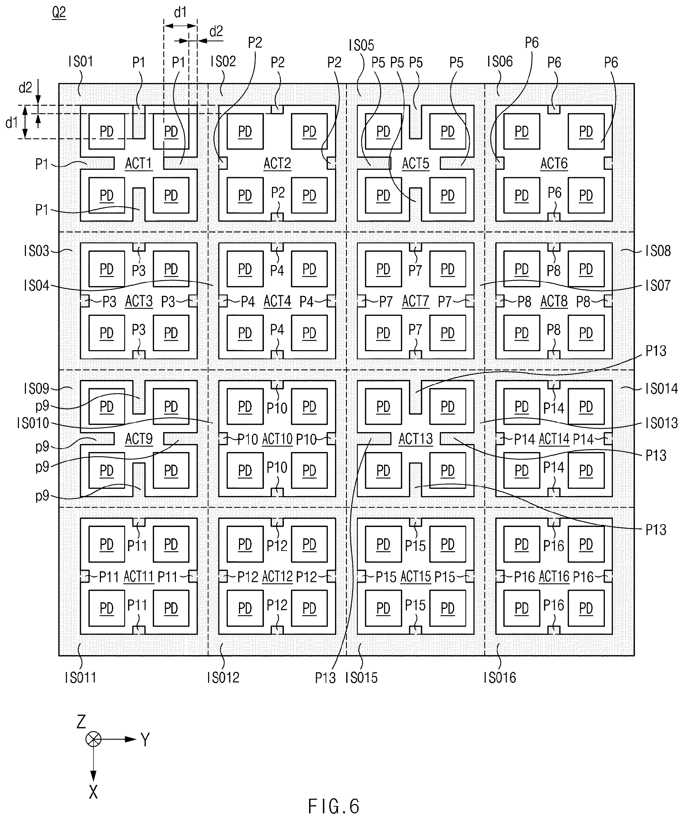

In a saturation environment in which high-sensitivity pixels, which are more sensitive to incident light and receive relatively large amount of incident light, are saturated, an embodiment with two low-sensitivity pixels may be more advantageous than an embodiment with one low-sensitivity pixel. On the other hand, in an environment in which high-sensitivity pixels are not saturated, an embodiment with three high-sensitivity pixels may be more advantageous than an embodiment with two high-sensitivity pixels. The above description may also be similarly applied to the embodiment of FIG. 6.

FIG. 4 is a cross-sectional view 40 illustrating an example of the pixel array taken along the line A-A' shown in FIG. 3 based on some embodiments of the present disclosure.

Referring to FIGS. 3 and 4, the cross-section 40 may include a first microlens (ML1), a second microlens (ML2), a fifth microlens (ML5), a sixth microlens (ML6), a first color filter (CF1), a second color filter (CF2), a fifth color filter (CF5), a sixth color filter (CF6), a grid structure (GRD), an anti-reflection layer (AR), and a semiconductor layer 400.

The first microlens (ML1) may be disposed on the first color filter (CF1). The first microlens (ML1) may collect incident light received from the outside, and may transmit the collected light to the first color filter (CF1). For example, the first microlens (ML1) may include a material such as a light transmissive resin or a light transmissive photoresist.

The second microlens (ML2) may be disposed on the second color filter (CF2). The second microlens (ML2) may collect incident light received from the outside, and may transmit the collected light to the second color filter (CF2). The second microlens (ML2) may include the same material as the first microlens (ML1).

The fifth microlens (ML5) may be disposed on the fifth color filter (CF5). The fifth microlens (ML5) may collect incident light received from the outside, and may transmit the collected light to the fifth color filter (CF5). The fifth microlens (ML5) may include the same material as the first microlens (ML1).

The sixth microlens (ML6) may be disposed on the sixth color filter (CF6). The sixth microlens (ML6) may collect incident light received from the outside, and may transmit the collected light to the sixth color filter (CF6). The sixth microlens (ML6) may include the same material as the first microlens (ML1).

The first color filter (CF1) may selectively transmit light of a first wavelength range from among the incident light collected from the first microlens (ML1). The first color filter (CF1) may be disposed below the first microlens (ML1). The first color filter (CF1) may be disposed on the anti-reflection layer (AR). The first color filter (CF1) may be disposed between the grid structures (GRDs).

The second color filter (CF2) may selectively transmit light of a first wavelength range from among the incident light collected from the second microlens (ML2). The second color filter (CF2) may be disposed below the second microlens (ML2). The second color filter (CF2) may be disposed on the anti-reflection layer (AR). The second color filter (CF2) may be disposed between the grid structures (GRDs).

The fifth color filter (CF5) may selectively transmit light of a second wavelength range from among the incident light collected from the fifth microlens (ML5). The fifth color filter (CF5) may be disposed below the fifth microlens (ML5). The fifth color filter (CF5) may be disposed on the anti-reflection layer (AR). The fifth color filter (CF5) may be disposed between the grid structures (GRDs).

The sixth color filter (CF6) may selectively transmit light of a second wavelength range from among the incident light collected from the sixth microlens (ML6). The sixth color filter (CF6) may be disposed below the sixth microlens (ML6). The sixth color filter (CF6) may be arranged on the anti-reflection layer (AR). The sixth color filter (CF6) may be disposed between the grid structures (GRDs).

The grid structure (GRD) may be disposed on the anti-reflection layer (AR). The grid structure (GRD) may be disposed at a boundary between two adjacent pixels (e.g., the first pixel PX1 and the second pixel PX2). The grid structure (GRD) may be disposed on the anti-reflection layer (AR). The grid structure (GRD) may prevent incident light obliquely received from the outside from being incident upon adjacent pixels, thereby reducing crosstalk between the adjacent pixels.

The anti-reflection layer (AR) may be disposed on a back surface 401 of the semiconductor layer 400. The back surface 401 may mean a surface of the semiconductor layer 400 upon which incident light is incident. The anti-reflection layer (AR) may include one or more layers having different refractive indices. The anti-reflection layer (AR) may include a material having high light transmittance so that light of a specific wavelength that has passed through the color filter (CF1, CF2, CF5, or CF6) can be easily transferred to the photoelectric conversion element. For example, the anti-reflection layer AR may include silicon oxide, silicon nitride, hafnium nitride, or the like.

The semiconductor layer 400 may include a first pixel isolation structure (ISO1), a second pixel isolation structure (ISO2), a fifth pixel isolation structure (ISO5), a sixth pixel isolation structure (ISO6), a first protrusion (P1), a fifth protrusion (P5), a first active region (ACT1), a second active region (ACT2), a fifth active region (ACT5), a sixth active region (ACT6), and a plurality of photoelectric conversion elements (PDs).

The first pixel isolation structure (ISO1) may be a structure that contacts the boundary of the first pixel (PX1) within the first pixel (PX1). The first pixel isolation structure (ISO1) may contact the side surfaces of the first active region (ACT1). The first pixel isolation structure (ISO1) may include a predetermined insulation layer (not shown) and a predetermined conductive layer (not shown). The insulation layer may include an insulation material (e.g., silicon oxide, silicon nitride, etc.). The insulation layer may electrically isolate the conductive layer from two adjacent active regions (e.g., the first and second active regions ACT1 and ACT2). The insulation layer may have a structure that surrounds the conductive layer. The conductive layer may be a region to which a voltage is applied to reduce dark noise of the first pixel (PX1). The conductive layer may include a conductive material (e.g., polysilicon, doped polysilicon), etc. The first pixel isolation structure (ISO1) may prevent light having penetrated the anti-reflection layer (AR) from being incident upon a pixel (e.g., the second pixel PX2) adjacent to the first pixel (PX1).

The first protrusion (P1) may be formed near the center of the first active region (ACT1). Both sides of the first protrusion (P1) may be formed to contact the first active region (ACT1). The first protrusion (P1) may include the same material as the first pixel isolation structure (ISO1). The first protrusion (P1) may prevent light that has been obliquely incident upon the first pixel (PX1) and has penetrated the first color filter (CF1) from being incident on another adjacent photoelectric conversion element (PD) within the same pixel. The first protrusion (P1) may reduce the crosstalk phenomenon between two photoelectric conversion elements (PDs) spaced apart from each other within the same pixel. In addition, the amount of light incident upon the photoelectric conversion element (PD) may be reduced by the first protrusion (P1).

The second pixel isolation structure (ISO2) may be a structure that contacts a boundary of the second pixel (PX2) within the second pixel (PX2). The second pixel isolation structure (ISO2) may contact the side surfaces of the second active region (ACT2). The second pixel isolation structure (ISO2) may include a predetermined insulation layer (not shown) and a conductive layer (not shown). The insulation layer may include the insulation material. The conductive layer may include the conductive material. The insulation layer may electrically isolate the conductive layer from two adjacent active regions (e.g., the first and second active regions ACT1 and ACT2). The insulation layer may have a structure that surrounds the conductive layer. The conductive layer may be a region to which a voltage is applied to reduce dark noise of the second pixel (PX2). The second pixel isolation structure (ISO2) may prevent light having penetrated the anti-reflection layer (AR) from being incident upon a pixel (e.g., the first pixel PX1 or the fifth pixel PX5) adjacent to the second pixel (PX2).

The fifth pixel isolation structure (ISO5) may be a structure that contacts a boundary of the fifth pixel (PX5) within the fifth pixel (PX5). The fifth pixel isolation structure (ISO5) may contact the side surfaces of the fifth active region (ACT5). The fifth pixel isolation structure (ISO5) may include a predetermined insulation layer and a conductive layer. The insulation layer may include the insulation material. The conductive layer may include the conductive material. The insulation layer may electrically isolate the conductive layer from two adjacent active regions (e.g., the fifth and sixth active regions ACT5 and ACT6). The insulation layer may have a structure that surrounds the conductive layer. The conductive layer may be a region to which a voltage is applied to reduce dark noise of the fifth pixel (PX5). The fifth pixel isolation structure (ISO5) may prevent light having penetrated the anti-reflection layer (AR) from being incident upon a pixel (e.g., the sixth pixel PX6) adjacent to the fifth pixel (PX5).

The fifth protrusion (P5) may be formed near the center of the fifth active region (ACT5). Both sides of the fifth protrusion (P5) may be formed to contact the fifth active region (ACT5). The fifth protrusion (P5) may include the same material as the fifth pixel isolation structure (ISO5). The fifth protrusion (P5) may prevent light that has been obliquely incident upon the fifth pixel (PX5) and has penetrated the fifth color filter (CF5) from being incident on another photoelectric conversion element (PD) within the same pixel. The fifth protrusion (P5) may reduce the crosstalk phenomenon between two photoelectric conversion elements (PDs) spaced apart from each other within the same pixel. In addition, the amount of light incident upon the photoelectric conversion element (PD) may be reduced by the fifth protrusion (P5).

The sixth pixel isolation structure (ISO6) may be a structure that contacts a boundary of the sixth pixel (PX6) within the sixth pixel (PX6). The sixth pixel isolation structure (ISO6) may contact the side surfaces of the sixth active region (ACT6). The sixth pixel isolation structure (ISO6) may include a predetermined insulation layer (not shown) and a conductive layer (not shown). The insulation layer may include an insulation material (e.g., silicon oxide, silicon nitride, etc.). The conductive layer may include a conductive material (e.g., polysilicon, doped polysilicon, etc.). The insulation layer may electrically isolate the conductive layer from two adjacent active regions (e.g., the fifth and sixth active regions ACT5 and ACT6). The insulation layer may have a structure that surrounds the conductive layer. The conductive layer may be a region to which a voltage is applied to reduce dark noise of the sixth pixel (PX6). The sixth pixel isolation structure (ISO6) may prevent light having penetrated the anti-reflection layer (AR) from being incident upon a pixel (e.g., the fifth pixel PX5) adjacent to the sixth pixel (PX6).

Each of the plurality of photoelectric conversion elements (PDs) may generate photocharges in response to incident light. Each of the photoelectric conversion elements (PDs) may include impurities of a conductive type opposite to that of the active region.

FIG. 5 is a graph illustrating changes in sensitivity and changes in crosstalk according to the lengths of protrusions shown in FIG. 3 based on some embodiments of the present disclosure.

Referring to FIGS. 3 and 5, the horizontal axis of the graph of FIG. 5 represents a distance between opposing protrusions included in each pixel of FIG. 3. The distance increases toward the left of the horizontal axis of the graph and decreases toward the right of the horizontal axis.

In the graph of FIG. 5, the first vertical axis represents the sensitivity of each pixel of FIG. 3. The sensitivity increases toward the top of the first vertical axis of the graph.

The second vertical axis of the graph of FIG. 5 represents the degree of crosstalk within each pixel of FIG. 3. The degree of crosstalk is a value obtained by dividing a light signal not corresponding to a corresponding pixel by a light signal corresponding to a corresponding pixel.

For example, in the case of a pixel (hereinafter referred to as a green pixel) that generates an electric signal in response to green light, the degree of crosstalk may satisfy Equation 1 below. [Equation 1] 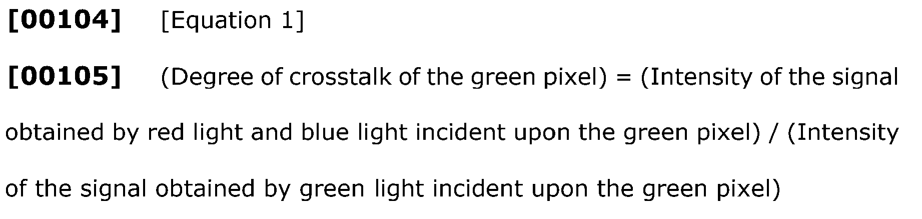 (Degree of crosstalk of the green pixel) = (Intensity of the signal obtained by red light and blue light incident upon the green pixel) / (Intensity of the signal obtained by green light incident upon the green pixel)

Similarly, the degree of crosstalk of the pixel generating an electric signal in response to red light may be a value obtained by dividing the intensity of the signal obtained by green light and blue light among the incident light by the intensity of the signal obtained by red light among the incident light. The degree of crosstalk of the pixel generating an electric signal in response to blue light may be a value obtained by dividing the intensity of the signal obtained by red light and green light among the incident light by the intensity of the signal obtained by blue light among the incident light.

A crosstalk curve (LC) shows how the degree of crosstalk occurrence between different photoelectric conversion elements included in the pixel is related to a length of the protrusion arranged between the photoelectric conversion elements.

A sensitivity curve (LS) shows the change in sensitivity of the pixel according to the length of the protrusion arranged between the photoelectric conversion elements.

Hereinafter, the first and second pixels (PX1, PX2) among the first to sixteenth pixels (PX1~PX16) of FIG. 3 will be described as representative examples.

For example, the first protrusions (P1) arranged between two different photoelectric conversion elements (PDs) included in the first pixel (PX1) may have a first length (d1). The distance between the two first protrusions (P1) each having the first length (d1) may be a first distance (W1).

The second protrusions (P2) arranged between two different photoelectric conversion elements (PDs) included in the second pixel (PX2) may have a second length (d2). The distance between the two second protrusions (P2) each having the second length (d2) may be a second distance (W2).

The first pixel (PX1) may have a first sensitivity (S1). The degree of crosstalk within the first pixel (PX1) may be denoted by a first crosstalk (C1). The second pixel (PX2) may have a second sensitivity (S2). The degree of crosstalk within the second pixel (PX2) may be denoted by a second crosstalk (C2).

Since the first length (d1) is longer than the second length (d2), the first distance (W1) may be shorter than the second distance (W2).

When the distance (e.g., the first distance W1 and/or the second distance W2) between the protrusions facing each other increases, optical loss decreases, which may improve the sensitivity and crosstalk of the pixel. When the distance between the protrusions facing each other decreases, the optical loss increases, which may deteriorate the sensitivity and crosstalk of the pixel. However, the isolation effect between different photoelectric conversion elements within the same pixel may increase, which may reduce the degree of movement of overflow photocharges.

As the distance between the protrusions facing each other increases, the length of the protrusions decreases, which may reduce the amount of incident light impinging on the protrusions, thereby increasing light efficiency and light sensitivity. In addition, taking the green pixel as an example, as the distance between the protrusions facing each other increases, the intensity of the green light incident upon the green pixel may increase (i.e., the denominator of Equation 1 may increase). In addition, since the length of the protrusion is short, the intensity of red light and blue light scattered by the protrusion of the pixel adjacent to the green pixel and penetrating into the green pixel may decrease (i.e., the numerator of Equation 1 may decrease). Accordingly, as the distance between the protrusions facing each other increases, the crosstalk may also decrease.

Therefore, the first sensitivity (S1) may be lower than the second sensitivity (S2). In addition, the first crosstalk (C1) may be greater than the second crosstalk (C2).

In one embodiment in which two photoelectric conversion elements are allocated to each pixel, the image sensing device 10 of FIG. 1 may output a pixel signal according to a summation mode that outputs a pixel signal by summing the incident lights respectively detected through the two photoelectric conversion elements. The image sensing device 10 of FIG. 1 may focus an image according to a Phase Detection AutoFocus (PDAF) mode by using each of the two photoelectric conversion elements included in the same pixel.

According to one embodiment of the present disclosure, when the summation mode is used for the second pixel (PX2) having a relatively high sensitivity, a pixel signal with improved sensitivity can be output. In addition, in the case of the first pixel (PX1) having a relatively low sensitivity, since optical isolation between the two photoelectric conversion elements included in the first pixel (PX1) is stronger than that of the second pixel (PX2), image focus may be more accurately adjusted when the first pixel (PX1) operates in the PDAF mode.

Embodiments of the present disclosure may provide an image sensing device (e.g., 10 of FIG. 1) having desired sensitivity and PDAF operating characteristics by adjusting the length of the protrusion of each pixel and the distance between the protrusions facing each other.

The content described above with reference to FIG. 5 can also be equally or similarly applied to an embodiment (e.g., the embodiment of FIG. 6) in which each pixel includes four photoelectric conversion elements instead of two photoelectric conversion elements.

FIG. 6 is a plan view illustrating a second embodiment of the pixel region (Q2) shown in FIG. 2 based on some embodiments of the present disclosure.

Referring to FIGS. 2, 3, and 6, the pixel region (Q2) according to the second embodiment may include first to fourth pixel groups (PG1~PG4). The first to fourth pixel groups (PG1~PG4) may be arranged in a (2 × 2) matrix structure.

In order to prevent overcrowding of the drawing, reference numbers of the first to sixteenth pixels (PX1~PX16) are not indicated, but the areas corresponding to the pixels (PX1~PX16) can be clearly distinguished from each other according to the content described with reference to FIG. 2.

In the following description, descriptions overlapping with those of the pixel region (Q1) of the first embodiment will herein be omitted as much as possible. The following embodiments will hereinafter be described with a focus on characteristics that are different from those of the pixel region (Q1) of the first embodiment.

The first to fourth pixels (PX1~PX4) included in the first pixel group (PG1) may be pixels that detect light in the first wavelength range. The fifth to eighth pixels (PX5~PX8) included in the second pixel group (PG2) may be pixels that detect light in the second wavelength range. The ninth to twelfth pixels (PX9~PX12) included in the third pixel group (PG3) may be pixels that detect light in the third wavelength range. The thirteenth to sixteenth pixels (PX13~PX16) included in the fourth pixel group (PG4) may be pixels that detect light in the first wavelength range.

Each of the first to sixteenth pixels (PX1~PX16) may include four photoelectric conversion elements and four protrusions.

For example, in the case of the first pixel (PX1), the first protrusion (P1) may extend from each boundary of the first pixel isolation structure (ISO1) along the first direction (X) and a direction opposite to the first direction (X). The first protrusion (P1) may extend from each boundary of the first pixel isolation structure (ISO1) along the second direction (Y) and a direction opposite to the second direction (Y). Each of the four first protrusions (P1) may extend to the center of the first pixel (PX1) by the first length (d1).

In the case of the second pixel (PX2), the second protrusion (P2) may extend from each boundary of the second pixel isolation structure (ISO2) in each of the first direction (X), the opposite direction of the first direction (X), the second direction (Y), and the opposite direction of the second direction (Y). Each of the second protrusions (P2) may extend to the center of the second pixel (PX2) by the second length (d2).

The third to sixteenth pixels (PX3~PX16) may be configured such that the four protrusions extend to the center of each pixel in the first direction (X), the opposite direction of the first direction (X), the second direction (Y), and the opposite direction of the second direction (Y), respectively.

Each of the first, fifth, ninth, and thirteenth protrusions (P1, P5, P9, P13) may extend by a first length (d1). Each of the second to fourth, sixth to eighth, tenth to twelfth, and fourteenth to sixteenth protrusions (P2~P4, P6~P8, P10~P12, P14~P16) may extend by the second length (d2).

Each pixel is configured such that four photoelectric conversion elements are arranged in a (2 × 2) matrix structure and a protrusion is disposed between two photoelectric conversion elements adjacent to each other in the first direction (X) or the second direction (Y) may operate not only in the summation mode and the PDAF mode but also in an All-4-Coupled (A4C) mode.

According to the second embodiment of the present disclosure, even when the image sensing device operates in the A4C mode, the degrees of optical isolation between the photoelectric conversion elements having different sensitivities in pixels that detect light of the same wavelength range are different from each other, so that the second embodiment can provide the evolved image sensing device (10 of FIG. 1) that can quickly process high-resolution images and produces high-quality images.

In the image sensing device according to the embodiments of the present disclosure, whereas each of the second to fourth protrusions (P2~P4) may be shorter than the first protrusion (P1), the second to fourth protrusions (P2~P4) may have the same or different lengths. Similarly, each of the sixth to eighth protrusions (P6~P8) may be shorter than the fifth protrusion (P5), but each of the sixth to eighth protrusions (P6~P8) may have the same length or different lengths. Whereas each of the tenth to twelfth protrusions (P10~P12) may be shorter than the ninth protrusion (P9), the tenth to twelfth protrusions (P10~P12) may have the same length or different lengths. Whereas each of the fourteenth to sixteenth protrusions (P14~P16) may be shorter than the thirteenth protrusion (P13), the fourteenth to sixteenth protrusions (P14~P16) may have the same length or different lengths.

As is apparent from the above description, the image sensing device based on some embodiments of the present disclosure has a high dynamic range (HDR) by varying the sensitivities of pixels that detect light of the same wavelength range without designing a separate complex circuit.

The embodiments of the present disclosure may provide a variety of effects capable of being directly or indirectly recognized through the above-mentioned patent document.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and/or illustrated in this patent document.

## Claims

1. An image sensing device comprising:
a first pixel including a first active region configured to receive and detect light of a first wavelength range, and a plurality of first protrusions, each first protrusion extending into the first active region by a first length; and
a second pixel including a second active region configured to receive and detect the light of the first wavelength range, and a plurality of second protrusions, each second protrusion extends into the second active region by a second length shorter than the first length.

2. The image sensing device according to claim 1, wherein:
the plurality of first protrusions extends from one side of a first pixel isolation structure surrounding the first active region to a center of the first active region; and
the plurality of second protrusions extends from one side of a second pixel isolation structure surrounding the second active region to a center of the second active region.

3. The image sensing device according to claim 2, wherein:
the first pixel includes first and second photoelectric conversion elements that are configured to detect light of the first wavelength range, wherein each of the first protrusions is disposed between the first and second photoelectric conversion elements; and
the second pixel includes third and fourth photoelectric conversion elements that are configured to detect light of the first wavelength range, wherein each of the second protrusions is disposed between the third and fourth photoelectric conversion elements.

4. The image sensing device according to claim 2, wherein:
the first pixel includes first photoelectric conversion element, second photoelectric conversion element, third photoelectric conversion element and fourth photoelectric conversion element that are configured to detect light of the first wavelength range; and
the second pixel includes fifth photoelectric conversion element, sixth photoelectric conversion element, seventh photoelectric conversion element and eighth photoelectric conversion element that are configured to detect light of the first wavelength range.

5. The image sensing device according to claim 4, wherein:
the first protrusion disposed between the first and second photoelectric conversion elements extends in a first direction;
the first protrusion disposed between third and fourth photoelectric conversion elements extends in a direction opposite to the first direction;
the first protrusion disposed between the first and third photoelectric conversion elements extends in a second direction different from the first direction; and
the first protrusion disposed between the second and third photoelectric conversion elements extends in a direction opposite to the second direction.

6. The image sensing device according to claim 5, wherein:
the second protrusion disposed between the fifth and sixth photoelectric conversion elements extends in the first direction;
the second protrusion disposed between the seventh and eighth photoelectric conversion elements extends in a direction opposite to the first direction;
the second protrusion disposed between the fifth and seventh photoelectric conversion elements extends in the second direction; and
the second protrusion disposed between the sixth and seventh photoelectric conversion elements extends in a direction opposite to the second direction.

7. The image sensing device according to claim 1, wherein:
the first pixel has a lower sensitivity than the second pixel.

8. The image sensing device according to claim 1, further comprising:
a third pixel including a third active region configured to receive light of a second wavelength range, and a third protrusion extending into the third active region by a third length; and
a fourth pixel including a fourth active region configured to receive the light of the second wavelength range, and a fourth protrusion extending into the fourth active region by the third length.

9. The image sensing device according to claim 1, further comprising:
a third pixel including a third active region configured to receive the light of the first wavelength range, and a third protrusion extending into the third active region by the second length; and
a fourth pixel including a fourth active region configured to receive the light of the first wavelength range, and a fourth protrusion extending into the fourth active region by the second length.

10. The image sensing device according to claim 9, further comprising:
a fifth pixel including a fifth active region configured to receive light of a second wavelength range, and a fifth protrusion extending into the fifth active region by the first length;
a sixth pixel including a sixth active region configured to receive the light of the second wavelength range, and a sixth protrusion extending into the sixth active region by the second length;
a seventh pixel including a seventh active region configured to receive the light of the second wavelength range, and a seventh protrusion extending into the seventh active region by the second length; and
an eighth pixel including an eighth active region configured to receive the light of the second wavelength range, and an eighth protrusion extending into the eighth active region by the second length.

11. An image sensing device comprising:
a pixel array including a plurality of pixels structured to detect incident light to generate electrical signals carrying images in the incident light and a pixel isolation structure disposed along boundaries of the plurality of pixels;
wherein the plurality of pixels in the pixel array are configured to include:
a first pixel group including first and second pixels that are configured to detect light of a first wavelength range,
wherein
the first pixel includes a plurality of first protrusions, each first protrusion extending from the pixel isolation structure to a center of the first pixel by a first length; and
the second pixel includes a plurality of second protrusions, each second protrusion extending from the pixel isolation structure to a center of the second pixel by a second length shorter than the first length.

12. The image sensing device according to claim 11, wherein the plurality of first protrusions includes:
a first protrusion extending from the pixel isolation structure in a first direction; and
another first protrusion extending from the pixel isolation structure in a direction opposite to the first direction.

13. The image sensing device according to claim 12, wherein the plurality of first protrusions further includes:
a first protrusion extending from the pixel isolation structure in a second direction; and
another first protrusion extending from the pixel isolation structure in a direction opposite to the second direction.

14. The image sensing device according to claim 13, wherein the first pixel group further includes:
third and fourth pixels configured to detect light of the first wavelength range,
wherein
the first to fourth pixels are arranged in a (2 × 2) matrix structure.

15. The image sensing device according to claim 13, wherein:
the third pixel includes a plurality of third protrusions, each third protrusion extending from the pixel isolation structure to a center of the third pixel by the first length; and
the fourth pixel includes a plurality of fourth protrusions, each fourth protrusion extending from the pixel isolation structure to a center of the fourth pixel by the second length.
